Europäisches Patentamt

European Patent Office

Office européen des brevets

(11) Veröffentlichungsnummer: **0 348 879**

**A1**

(12) # EUROPÄISCHE PATENTANMELDUNG

(21) Anmeldenummer: 89111647.7

(22) Anmeldetag: 27.06.89

(51) Int. Cl.4: **G06F 1/00 , G05F 1/565 , G05F 1/577 , H03K 17/30**

(30) Priorität: 29.06.88 DE 3821913

(43) Veröffentlichungstag der Anmeldung:
03.01.90 Patentblatt 90/01

(84) Benannte Vertragsstaaten:
CH FR GB IT LI SE

(71) Anmelder: **HONEYWELL REGELSYSTEME GMBH**
**Kaiserleistrasse 39**
**D-6050 Offenbach am Main(DE)**

(72) Erfinder: **Hau, Heinz**
**Langstrasse 6**
**D-6455 Erlensee(DE)**
Erfinder: **Ludwig, Adolf**
**Limesstrasse 22**
**D-6477 Limeshain 1(DE)**

(74) Vertreter: **Herzbach, Dieter et al**
**Honeywell Europe S.A. Holding KG Patent-**
**und Lizenzabteilung Kaiserleistrasse 39**
**Postfach 10 08 65**
**D-6050 Offenbach am Main(DE)**

(54) **Schaltungsanordnung zur Erzeugung einer Versorgungsspannung.**

(57) Die langsam und temperaturabhängig ansteigende Spannung einer aktivierbaren Batterie (K1, B1; K2, B2) wird durch einen Durchflußwandler (V3, C2, R3, TR1, C3) hochtransformiert und lädt einen Speicherkondensator (C4) auf. Zwischen dem Speicherkondensator (C4) und dem Spannungsversorgungseingang ($V_{DD}$) eines Mikroprozessors ($\mu p$) ist ein elektronischer Schalter (V7) angeordnet, der über einen Spannungsteiler (V5, R5, R6, R7) an seiner Steuerelektrode durchgeschaltet wird, wenn die Spannung an dem Speicherkondensator (C4) einen vorgegebenen Wert übersteigt. Ein Spannungsregler (V9) regelt und begrenzt die Spannung auf den von dem Mikroprozessor benötigten Wert.

## Schaltungsanordnung zur Erzeugung einer Versorgungsspannung

Die vorliegende Erfindung bezieht sich auf eine Schaltungsanordnung nach dem Gattungsbegriff des Patentanspruches 1.

Eine solche Schaltungsanordnung findet insbesondere Anwendung bei der Spannungsversorgung eines Mikroprozessors. Bestimmte Einrichtungen, wie beispielsweise Raketenzünder, verwenden Mikroprozessoren, um bestimmte Signale zu verarbeiten, Verzögerungszeiten vorzugeben und gewisse Funktionen auszulösen. Andererseits verwenden diese Einrichtungen Batterien, die erst im Bedarfsfall aktiviert werden und dann eine langsam ansteigende temperaturabhängige Spannung mit relativ geringem Wert erzeugen. Daher wird im allgemeinen die durch die Batterie erzeugte Spannung noch hochtransformiert, um z.B. eine Zündspannung zu erzeugen. Will man die gleiche Spannungsquelle benutzen um den Mikroprozessor mit Spannung zu versorgen, so ergeben sich Schwierigkeiten, da der Mikroprozessor für einen ordnungsgemäßen Betrieb eine Versorgungsspannung mit definiertem steilem Anstieg braucht. Nur dann ist gewährleistet, daß der interne Power-On-Reset einwandfrei arbeitet.

Es ist die Aufgabe der vorliegenden Erfindung, eine Schaltungsanordnung anzugeben, die einen solchen definierten steilen Spannungsanstieg gewährleistet, wenn die Spannungsquelle selbst einen langsamen temperaturabhängigen Spannungsanstieg aufweist. Die Lösung dieser Aufgabe gelingt gemäß den kennzeichnenden Merkmalen des Patentanspruches 1. Weitere vorteilhafte Ausgestaltungen der erfindungsgemäßen Schaltungsanordnung sind den Unteransprüchen entnehmbar.

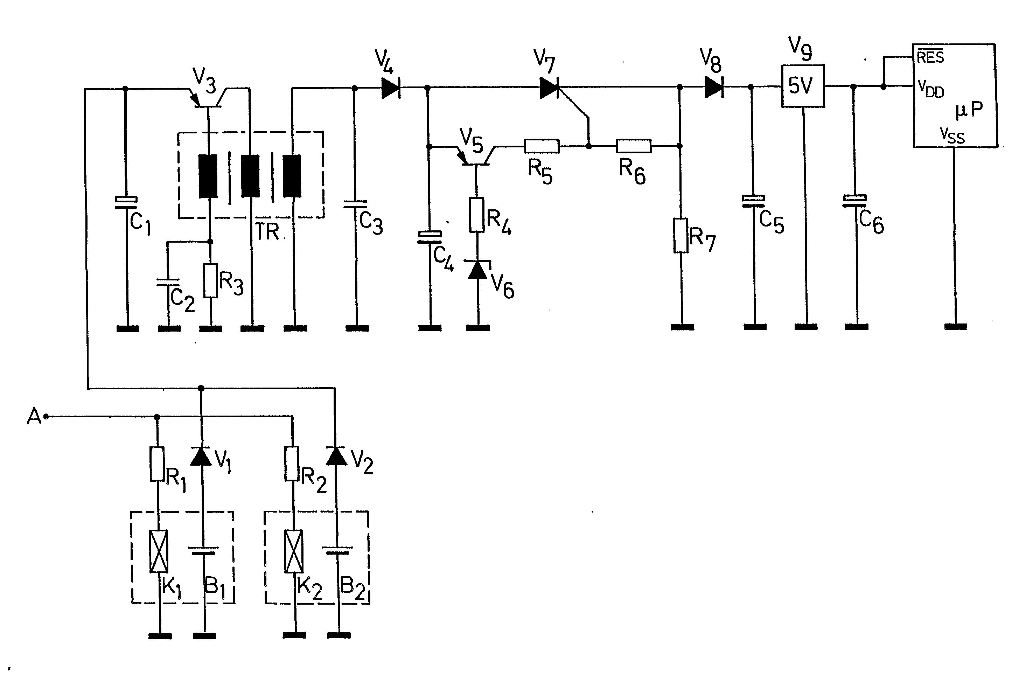

Anhand der einzigen Figur der beiliegenden Zeichnung sei im folgenden die erfindungsgemäße Schaltungsanordnung nach Aufbau und Funktion näher beschrieben.

Über einen Anschluß A wird ein in nicht-dargestellter Weise während der Programmierung eines Zünders aufgeladener Kondensator über einen beim Abschuß des Raketenzünders mechanisch betätigten und ebenfalls nicht dargestellten Schalter auf die Kraftelemente K1 und K2 der Batterien B1 und B2 entladen, wobei die Ansteuerung der Kraftelemente über die Widerstände R1 und R2 erfolgt und die Batterien durch Dioden V1 und V2 voneinander entkoppelt sind. Die auf diese Weise aktivierten Batterien B1 und B2 geben eine Spannung ab, die langsam auf einen Maximalwert von 3,6V ansteigt. Ein typischer Wert für die Anstiegszeit ist 200ms. Bei Kurzschluß einer Batterie kann die andere Batterie einwandfrei arbeiten, da über die Dioden V1 und V2 eine Entkopplung erfolgt. Die Spannungsversorgung aus der Batterie ist daher redundant aufgebaut.

Mit der ansteigenden Batteriespannung wird ein Stützkondensator C1 aufgeladen. Mit der Spannung dieses Kondensators wird ein Durchflußwandler angesteuert, der einen Schalttransistor V3, einen Transformator TR, einen Kondensator C2, einen Widerstand R3 und einen Kondensator C3 umfaßt. Mit der Ausgangsspannung des Wandlers wird über eine Diode V4 ein Kondensator C4 aufgeladen. Dieser Kondensator C4 lädt sich entsprechend dem Anstieg der Batteriespannung auf maximal 30V auf. An den Kondensator C4 ist ein Thyristor V7 mit seiner Anode angeschlossen, während die Kathode dieses Thyristors über eine Diode V8 an einen Spannungsregler V9 angeschlossen ist. Die Steuerelektrode des Thyristors V7 ist an einen Spannungsteiler angeschlossen, der aus der Reihenschaltung eines Schalttransistors V5 und dreier Widerstände R5, R6 und R7 besteht. Der Schalttransistor V5 ist vom pnp-Leitfähigkeitstyp und ist mit seinem Emitter an den Ladekondensator C4 angeschlossen. Die Basis des Transistors V5 liegt über einen Widerstand R4 und eine Zenerdiode V6 an Bezugspotential. Durch die Zenerdiode V6 wird der Basis des Transistors V5 ein Potential vorgegeben, so daß dieser durchschaltet, wenn die Spannung über dem Kondensator C4 etwa 18V erreicht hat. Der Kollektor des Transistors V5 liegt über die Widerstände R5, R6 und R7 an Bezugspotential; wobei die Steuerelektrode des Thyristors V7 an den gemeinsamen Schaltungspunkt der Widerstände R5 und R6 angeschlossen ist und die Kathode des Thyristors V7 an den gemeinsamen Schaltungspunkt der Widerstände R6 und R7 angeschlossen ist. Wenn somit die Spannung über dem Kondensator C4 einen Wert von 18V erreicht, so schaltet der Transistor V5 durch, wodurch gleichzeitig der Thyristor V7 gezündet wird und die Ladung des Kondensators C4 über den Thyristor V7 und die Diode V8 auf einen Ladekondensator C5 übertragen wird. Hierbei wird der Ladekondensator C5 innerhalb von 1ms auf eine Spannung von mindestens 10V aufgeladen. Dieser Spannungssprung wird durch den nachgeschalteten Spannungsregler V9 auf 5V begrenzt und direkt dem Spannungsversorgungseingang $V_{DD}$ des Mikroprozessors µp zugeführt. Ein zwischen den Spannungsversorgungseingang und Bezugspotential geschalteter Kondensator C6 dient als Stützkondensator. Die Versorgungsspannung ist ferner auf den äußeren Reset-Eingang $\overline{RES}$ des Mikroprozessors µp geführt.

Der schnelle Anstieg der 5V-Versorgungsspannung in weniger als 2ms gewährleistet, daß der interne Power-On-Reset des Mikroprozessors in je-

dem Fall einwandfrei arbeitet.

**Ansprüche**

1. Schaltungsanordnung zur Erzeugung einer steil ansteigenden Versorgungsspannung für einen Mikroprozessor aus einer langsam ansteigenden Spannung, **gekennzeichnet durch** einen elektronischen Schalter (V7) zwischen einem die langsam ansteigende Spannung speichernden Kondensator (C4) und dem Versorgungsanschluß ($V_{DD}$) des Mikroprozessors ($\mu$p) und eine Betätigung des elektronischen Schalters (V7) bei Erreichen einer vorgegebenen Spannung an dem Kondensator (C4).

2. Schaltungsanordnung nach Anspruch 1, **dadurch gekennzeichnet,** daß ein Spannungsregler (V9) zwischen dem elektrischen Schalter (V7) und dem Mikroprozessor ($\mu$p) angeordnet ist.

3. Schaltungsanordnung nach Anspruch 1, **dadurch gekennzeichnet,** daß der elektronische Schalter aus einem Thyristor (V7) besteht, dessen Steuerelektrode an einen Spannungsteiler (R5, R6, R7) zwischen dem Speicherkondensator (C4) und einem Bezugspotential angeschlossen ist, wobei ein Schalttransistor (V5) in Reihe zu dem Spannungsteiler geschaltet ist, dessen Basis mit einer vorgegebenen Spannung beaufschlagt wird.

4. Schaltungsanordnung nach Anspruch 3, **dadurch gekennzeichnet,** daß die Basis des Schalttransistors (V5) über eine Zenerdiode (V6) an die Bezugsspannung angeschlossen ist.

5. Schaltungsanordnung nach Anspruch 1, **dadurch gekennzeichnet,** daß die langsam ansteigende Spannung durch wenigstens eine aktivierbare Batterie (K1, B1; K2, B2) erzeugt wird, deren Spannung über einen Durchflußwandler (V3, C2, R3, TR, C3) hochtransformiert und in dem Speicherkondensator (C4) gespeichert wird.

6. Schaltungsanordnung nach Anspruch 5, **dadurch gekennzeichnet,** daß zwei aktivierbare Batterien (K1, B1; K2, B2) über Dioden (V1, V2) entkoppelt an den Durchflußwandler angeschlossen sind.

7. Schaltungsanordnung nach Anspruch 2, **dadurch gekennzeichnet,** daß vor und hinter dem Spannungsregler (V9) jeweils ein Ladekondensator (C5, C6) angeordnet ist.

Honeywe

Europäisches Patentamt

**EUROPÄISCHER RECHERCHENBERICHT**

Nummer der Anmeldung

EP 89 11 1647

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN, Band 5, Nr. 191 (P-92)[863], 5. Dezember 1981; & JP-A-56 116 135 (SHARP K.K.) 11-09-1981 * Insgesamt * --- | 1,2,7 | G 06 F 1/00 G 05 F 1/565 G 05 F 1/577 H 03 K 17/30 |
| X | EP-A-0 226 725 (AKO-WERKE) * Seite 5, Zeile 24 - Seite 7, Zeile 24; Figuren 1,2 * --- | 1,4 | |
| A | DE-A-2 431 075 (PHILIPS) * Figur 1 * ----- | 5 | |

|  |
|---|
| RECHERCHIERTE SACHGEBIETE (Int. Cl.5) |
| G 06 F G 05 F H 03 K H 02 M |

Der vorliegende Recherchenbericht wurde für alle Patentansprüche erstellt

| Recherchenort | Abschlußdatum der Recherche | Prüfer |
|---|---|---|
| DEN HAAG | 13-09-1989 | ZAEGEL B.C. |